# EUROPEAN PATENT APPLICATION

(11) **EP 2 226 835 A1**
(43) Date of publication of application: **08.09.2010**
(21) Application number: 08867770.3
(22) Date of filing: 25.11.2008
(51) Int. Cl.: H01L 21/336, H01L 21/02, H01L 27/12, H01L 29/786

(54) **SEMICONDUCTOR DEVICE AND METHOD FOR MANUFACTURING THE SAME**

(30) Priority: 28.12.2007 JP 2007341077
(71) Applicant: Sharp Kabushiki Kaisha, Osaka-shi, Osaka 545-8522 (JP)
(72) Inventor: TADA, Kenshi, Osaka 545-8522 (JP); TAKAFUJI, Yutaka, Osaka 545-8522 (JP); FUKUSHIMA, Yasumori, Osaka 545-8522 (JP); TOMIYASU, Kazuhide, Osaka 545-8522 (JP); TAKEI, Michiko, Osaka 545-8522 (JP); NAKAGAWA, Kazuo, Osaka 545-8522 (JP); MATSUMOTO, Shin, Osaka 545-8522 (JP)
(74) Representative: Müller - Hoffmann & Partner
(86) International application number: PCT/JP2008/003463
(87) International publication number: WO 2009/084149

(57) **Abstract**

An element portion forming step includes an insulating film forming step of forming an insulating film on a surface of a base layer, a conductive layer forming step of uniformly forming a conductive layer on a surface of the insulating film, and an electrode forming step of patterning the conductive layer to form an electrode. A delamination layer forming step of ion implanting a delamination material into the base layer to form a delamination layer is performed before the electrode forming step.

## Description

### TECHNICAL FIELD

The present invention relates to semiconductor devices for use in, e.g., liquid crystal displays (LCDs), and manufacturing methods thereof.

### BACKGROUND ART

In recent years, so-called active matrix drive devices for driving liquid crystal display (LCD) panels, organic electroluminescence (EL) panels, and the like are known in the art. Such active matrix drive devices are semiconductor devices in which thin film transistors (TFTs) containing amorphous silicon (amorphous Si or a-Si) or polysilicon (_{P}-Si) are formed on arbitrary substrates larger than silicon (Si) wafers, such as glass substrates and quartz substrates. Formation of higher performance Si devices has been studied in order to integrate peripheral drivers, or systems for which higher performance is required, such as memories, microprocessors, image processors, and timing controllers, on substrates.

In particular, polysilicon has received attention as a material that is used to integrate peripheral drivers having high mobility and operating at a high speed. However, polysilicon has localized levels in bandgaps due to crystalline imperfection, and has defects and localized levels near grain boundaries, causing problems such as reduced mobility, an increased S coefficient (subthreshold coefficient), and the like.

Moreover, in the case of forming TFTs on those substrates, such as glass substrates, whose processing accuracy is lower than that of Si wafers, miniaturization of devices is limited due to the relatively low processing accuracy. This makes it difficult to integrate systems requiring more sophisticated element portions, such as memories, microprocessors, image processors, and timing controllers, on the glass substrates.

As a solution to the above problems, Patent Document 1, for example, discloses a technique for transferring an element portion, which includes a monocrystalline Si TFT formed on a silicon substrate, onto a glass substrate or the like. The technique of Patent Document 1 will be described with reference to FIGS. 24-27. FIGS. 24-27 are cross-sectional views illustrating a manufacturing process.

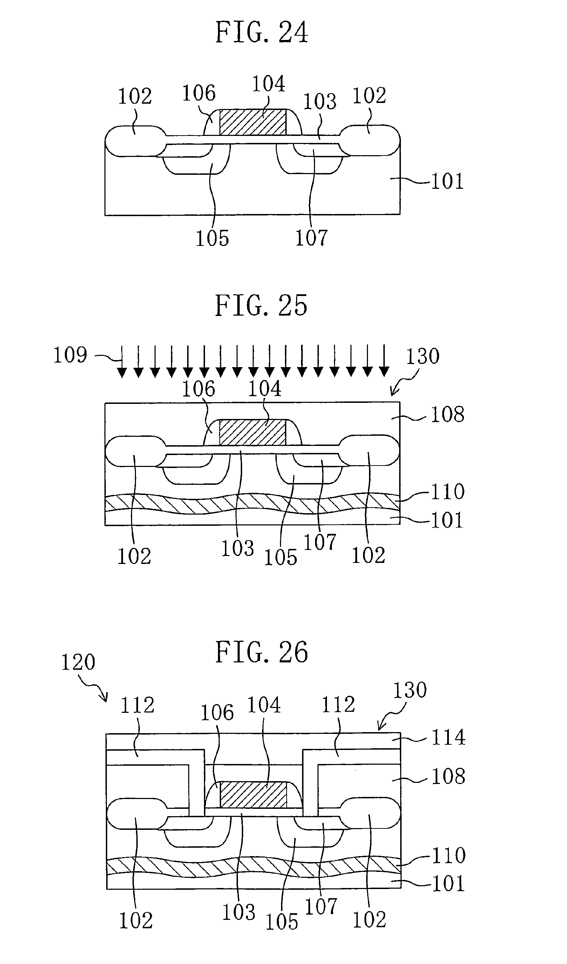

First, a monocrystalline Si TFT 130 of an element portion 120 is formed on a silicon substrate 101. More specifically, as shown in FIG. 24, element isolation films 102 and a gate insulating film 103 are formed on the surface of the silicon substrate 101, and a gate electrode 104 is formed on the gate insulating film 103. The gate electrode 104 is formed by patterning polysilicon deposited on the gate insulating film 103 by photolithography.

Next, by using the gate electrode 104 as a mask, an impurity element is ion implanted into the silicon substrate 101 to form lightly doped impurity regions 105. Then, sidewalls 106 are formed, and an impurity element is ion implanted into the silicon substrate 101 to form heavily doped impurity regions 107.

Thereafter, as shown in FIG. 25, a planarizing film 108 is formed over the silicon substrate 101 so as to cover the gate electrode 104 and the like, and hydrogen ions 109 are implanted into the silicon substrate 101 via the planarizing film 108. Thus, a delamination layer 110 including the hydrogen ions 109 is formed in the silicon substrate 101.

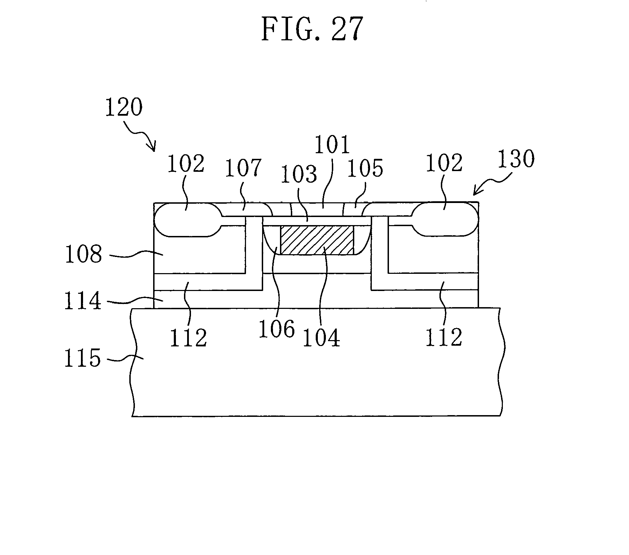

Subsequently, as shown in FIG. 26, metal layers 112 are formed on the planarizing film 108, and a protective film 114 is formed so as to cover the planarizing film 108 and the metal layers 112. Then, as shown in FIG. 27, the surface of the protective film 114 is planarized, and the silicon substrate 101 is bonded to a glass substrate 115 via the protective film 114 serving as an adhesive layer. Thereafter, a heat treatment is performed to separate and remove a part of the silicon substrate 101, which is located on a side opposite to the glass substrate 115, along the delamination layer 110. Then, the remaining silicon substrate 101 is etched toward the glass substrate 115 to control the thickness of the silicon layer in the element portion 120 including the monocrystalline Si TFT 130, thereby completing the transfer process. This method enables sophisticated element portions to be integrated on glass substrates.

### CITATION LIST

PATENT DOCUMENT
PATENT DOCUMENT 1: Japanese Published Patent Application No. 2004-165600

### SUMMARY OF THE INVENTION

### TECHNICAL PROBLEM

However, in the manufacturing method of Patent Document 1, the types of layers laminated in a region covered by the gate electrode 104 are different from those laminated in a region not covered by the gate electrode 104 on the silicon substrate 101. Thus, when hydrogen is ion implanted into the silicon substrate 101, the ion implantation depth can vary between these regions, whereby the delamination layer can be formed at different depths in these regions. This makes it difficult to control the final thickness of the silicon layer after the transfer process.

This problem is particularly significant in the case where gate electrodes are formed by silicide (especially polycide formed by silicidating polysilicon gate electrodes) which is commonly used in transistors in recent years.

Moreover, in the manufacturing method of Patent Document 1, hydrogen ions are implanted after formation of the planarizing film that covers the gate electrode. Thus, the hydrogen ions need to be accelerated at high energy, whereby the hydrogen ions are implanted in an excessively large area. In addition, since a hydrogen ion implantation region is formed so as to reflect the thickness distribution of the planarizing film, it is difficult to maintain a uniform implantation depth of the hydrogen ions.

The present invention was developed in view of the above problems, and it is a primary object of the present invention to reduce a variation in implantation depth of a delamination material in a base layer to form as flat a delamination layer as possible.

### SOLUTION TO THE PROBLEM

In order to achieve the above object, according to the present invention, a delamination layer is formed before patterning of an electrode.

More specifically, a method for manufacturing a semiconductor device according to the present invention includes: an element portion forming step of forming in a base layer an element portion that includes at least a part of an element including an electrode; a delamination layer forming step of ion implanting a delamination material into the base layer to form a delamination layer; a bonding step of bonding to the substrate the base layer having the element portion formed therein; and a separating step of separating and removing along the delamination layer a part of the base layer bonded to the substrate, where the element portion is not formed, wherein the element portion forming step includes an insulating film forming step of forming an insulating film on a surface of the base layer, a conductive layer forming step of uniformly forming a conductive layer on a surface of the insulating film, and an electrode forming step of patterning the conductive layer to form the electrode, and the delamination layer forming step is performed before the electrode forming step.

The method may further include a metal film forming step of laminating a metal film on a surface of the conductive layer, and in the electrode forming step, the conductive layer and the metal film may be patterned to form the electrode.

It is preferable that the surface of the conductive layer be planarized in the conductive layer forming step.

It is preferable that the delamination layer forming step be performed after the conductive layer forming step.

The conductive layer may be made of polysilicon.

It is preferable that the delamination material be hydrogen or an inert element.

It is preferable that the base layer be a monocrystalline silicon layer.

The substrate may be a glass substrate.

The electrode may form at least a part of a gate electrode of a MOS transistor.

It is preferable that a surface of the base layer, which is to be bonded to the substrate, be planarized in advance in the bonding step.

A semiconductor device according to the present invention includes: a substrate; a base layer bonded to the substrate with a part of the base layer being separated and removed along a delamination layer containing a delamination material; and an element portion including at least a part of an element, and formed in the base layer, wherein the delamination layer is formed in the base layer before an electrode of the element is patterned.

The electrode may be formed by a silicon layer portion and a metal layer portion laminated thereon.

It is preferable that the delamination material be hydrogen or an inert element.

It is preferable that the base layer be a monocrystalline silicon layer.

The substrate may be a glass substrate.

### [Functions]

Functions of the present invention will be described below.

When manufacturing the above semiconductor device, an element portion, which includes at least a part of an element including an electrode, is formed in a base layer such as, e.g., a monocrystalline silicon layer, in an element portion forming step.

An insulating film forming step, a conductive layer forming step, and an electrode forming step are performed in the element portion forming step. In the insulating film forming step, an insulating film is formed on the surface of the base layer. Then, in the conductive layer forming step, a conductive layer is uniformly formed on the surface of the insulating film. The conductive layer may be made of, e.g., polysilicon. The surface of the conductive layer may be planarized in this conductive layer forming step. This enables a flat delamination layer to be formed in a later delamination layer forming step.

Then, in the electrode forming step, the conductive layer is patterned to form an electrode. The electrode may be formed by, e.g., a silicon layer portion and a metal layer portion laminated thereon. In the case where the electrode has the metal layer portion, the electrode is formed by first performing a metal film forming step of laminating a metal film on the surface of the conductive layer, and then patterning the conductive layer and the metal layer in the electrode forming step. This electrode later forms at least a part of a gate electrode in a MOS transistor.

The delamination layer forming step is performed before the electrode forming step. In the delamination layer forming step, a delamination material such as, e.g., hydrogen or an inert element is ion implanted into the base layer to form a delamination layer in the base layer. This delamination layer forming step is preferably performed after, e.g., the conductive layer forming step. This can make the delamination layer to be less affected by heat that is applied to the base layer in other processes.

Then, a bonding step is performed to bond the base layer, having the element portion formed therein, to a substrate such as, e.g., a glass substrate. In this bonding step, the surface of the base layer, which is to be bonded to the substrate, may be planarized in advance. This enables the base layer and the substrate to be bonded together by self-bonding due to the van der Waals force.

Subsequently, a separating step is performed to separate and remove along the delamination layer a part of the base layer bonded to the substrate, where the element portion is not formed. The semiconductor device is formed in this manner.

### ADVANTAGES OF THE INVENTION

According to the present invention, the delamination layer is formed before the electrode is patterned. This reduces a variation in implantation depth of the delamination material in the base layer due to the shape of the electrode, thereby enabling a flat delamination layer to be formed in the base layer.

Moreover, since it is not necessary to implant a delamination material via a planarizing film that covers the electrode, the delamination layer can be formed at a shallow position at relatively low energy. As a result, the delamination layer can be formed at a uniform depth while suppressing damage to the base layer.

In addition, especially in the case where the electrode is formed by a conductive layer of, e.g., polysilicon and a metal film, the flatness of the delamination layer can be improved while increasing the conductive property of the electrode.

### BRIEF DESCRIPTION OF THE DRAWINGS

[FIG. 1] FIG. 1 is a cross-sectional view schematically showing the structure of a main part of a semiconductor device according to a first embodiment.
[FIG. 2] FIG. 2 is a cross-sectional view showing a delamination layer formed by ion implanting hydrogen via a polysilicon layer according to the first embodiment.
[FIG. 3] FIG. 3 is a cross-sectional view showing lightly doped impurity regions formed in a base layer according to the first embodiment.
[FIG. 4] FIG. 4 is a cross-sectional view showing heavily doped impurity regions formed in the base layer according to the first embodiment.
[FIG. 5] FIG. 5 is a cross-sectional view showing a protective insulating film, a source electrode, and a drain electrode according to the first embodiment.
[FIG. 6] FIG. 6 is a cross-sectional view showing a delamination layer formed by ion implanting hydrogen via a polysilicon layer according to a second embodiment.
[FIG. 7] FIG. 7 is a cross-sectional view showing lightly doped impurity regions formed in a base layer according to the second embodiment.
[FIG. 8] FIG. 8 is a cross-sectional view showing heavily doped impurity regions formed in the base layer according to the second embodiment.
[FIG. 9] FIG. 9 is a cross-sectional view showing a protective insulating film, a source electrode, and a drain electrode according to the second embodiment.
[FIG. 10] FIG. 10 is a cross-sectional view schematically showing the structure of a main part of a semiconductor device S according to a third embodiment.
[FIG. 11] FIG. 11 is a cross-sectional view showing a delamination layer formed by ion implanting hydrogen via a polysilicon layer according to the third embodiment.
[FIG. 12] FIG. 12 is a cross-sectional view showing lightly doped impurity regions formed in a base layer according to the third embodiment.
[FIG. 13] FIG. 13 is a cross-sectional view showing heavily doped impurity regions formed in the base layer according to the third embodiment.
[FIG. 14] FIG. 14 is a cross-sectional view showing a protective insulating film, a source electrode, and a drain electrode according to the third embodiment.
[FIG. 15] FIG. 15 is a cross-sectional view showing a delamination layer formed by ion implanting hydrogen via a polysilicon layer according to a fourth embodiment.
[FIG. 16] FIG. 16 is a cross-sectional view showing lightly doped impurity regions formed in a base layer according to the fourth embodiment.
[FIG. 17] FIG. 17 is a cross-sectional view showing heavily doped impurity regions formed in the base layer according to the fourth embodiment.
[FIG. 18] FIG. 18 is a cross-sectional view showing a protective insulating film, a source electrode, and a drain electrode according to the fourth embodiment.
[FIG. 19] FIG. 19 is a cross-sectional view showing planarized LOCOS oxide films.
[FIG. 20] FIG. 20 is a cross-sectional view showing an oxide film, a silicon nitride film, and a resist, which are formed on a silicon substrate 1.
[FIG. 21] FIG. 21 is a cross-sectional view showing grooves formed in the silicon substrate 1.
[FIG. 22] FIG. 22 is a cross-sectional view showing LOCOS oxide films formed in the grooves.
[FIG. 23] FIG. 23 is a cross-sectional view of a silicon substrate having element isolation insulating layers formed by STI.
[FIG. 24] FIG. 24 is a cross-sectional view showing a gate electrode, lightly doped impurity regions, and heavily doped impurity regions, which are formed in a conventional silicon substrate.
[FIG. 25] FIG. 25 is a cross-sectional view showing a delamination layer formed in the conventional silicon substrate.
[FIG. 26] FIG. 26 is a cross-sectional view showing metal layers and a protective film, which are formed in the conventional silicon substrate.
[FIG. 27] FIG. 27 is a cross-sectional view showing an element portion transferred to a conventional glass substrate.

### DESCRIPTION OF REFERENCE CHARACTERS

- S: Semiconductor Device
- D: Element Portion
- 1: Silicon Substrate (Base Layer)
- 10: LOCOS oxide film
- 13: Channel Region
- 14: Polysilicon Layer
- 16: Gate Oxide Film
- 17: Gate Electrode (Electrode)
- 18: Metal Film
- 19: Silicon Layer Portion (Electrode)
- 20: Metal Layer Portion (Electrode)
- 22: P-type Impurity Element
- 23: P-type Lightly Doped Impurity Region
- 29: P-type Impurity Element
- 30: P-type Heavily Doped Impurity Region
- 31: Planarizing Layer
- 32: Delamination Material, Hydrogen
- 33: Delamination Layer
- 35: Contact Hole
- 37: Protective Insulating Film
- 38: Glass Substrate (Substrate)
- 56: PMOS transistor

### DESCRIPTION OF EMBODIMENTS

Embodiments of the present invention will be described in detail below with reference to the accompanying drawings. Note that the present invention is not limited to the following embodiments.

### (First Embodiment)

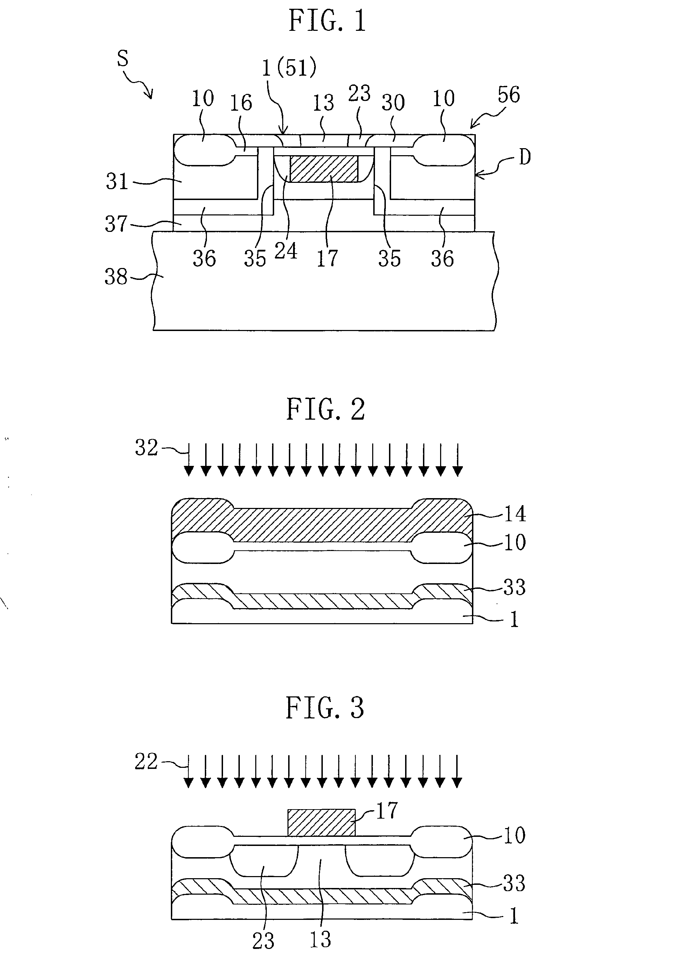

FIGS. 1-5 show a first embodiment of the present invention.

FIG. 1 is a cross-sectional view schematically showing the structure of a main part of a semiconductor substrate S. FIGS. 2-5 are cross-sectional views illustrating manufacturing steps of the semiconductor substrate S in the first embodiment.

The semiconductor device S is formed directly on a glass substrate 38 of, e.g., a display panel of an LCD, not shown, and is used as various functional circuits, such as, e.g., a driver circuit for driving and controlling a plurality of pixels of the display panel.

Although not shown in the figure, the LCD includes: a TFT substrate having a plurality of TFTs (transistors) formed thereon; a counter substrate provided so as to face the TFT substrate; and a liquid crystal layer interposed between the TFT substrate and the counter substrate. A common electrode, which is made of, e.g., indium tin oxide (ITO) or the like, color filters, and the like are formed on a glass substrate of the counter substrate. On the other hand, the plurality of TFTs, pixel electrodes, and the like are formed on the glass substrate 38 of the TFT substrate.

As shown in FIG. 1, the semiconductor device S includes a glass substrate 38, and element portions D formed at high density and with high accuracy in a base layer 1 over the glass substrate 38. The element portion D includes a transistor 56 as an element, and the transistor 56 is covered by a protective insulating film 37. Thus, the element portion D is bonded to the glass substrate 38 via the protective insulating film 37 by self-bonding. In other words, the base layer 1, together with the element portion D, is bonded to the glass substrate 38.

Note that, in the case where the semiconductor device S is used in transmissive LCDs, transparent substrates such as the glass substrate 38 are preferable as the substrate 38. However, in the case where the semiconductor device S is used in other LCDs, other substrates such as a monocrystalline silicon semiconductor substrate can be used as the substrate 38.

As shown in FIG. 1, the element portion D has, e.g., a P-channel metal oxide semiconductor (PMOS) transistor 56 as a semiconductor element. As shown in FIG. 1, local oxidation of silicon (LOCOS) oxide films 10, which serve as element isolation films, are formed as element isolation regions for electrically isolating transistors 56 from each other.

Note that although only one PMOS transistor 56 is shown in FIG. 1, elements that are formed are not limited to this. The present invention is similarly applicable to other elements, such as bipolar transistors and diodes as well as N-channel metal oxide semiconductor (NMOS) transistors. The number of elements is not limited, and one to millions of elements can be formed. The element portion D can be formed so as to include at least a part of the element.

The base layer 1 has an active region 51. The active region 51 has a lightly doped drain (LLD) structure formed by P-type lightly doped impurity regions 23 and P-type heavily doped impurity regions 30. The P-type lightly doped impurity regions 23 are formed on both sides (the left and right sides in the figure) of a channel region 13. The P-type heavily doped impurity regions 30 are formed outside the lightly doped impurity regions 23.

The base layer 1 is a semiconductor layer made of, e.g., a monocrystalline silicon semiconductor. Note that the base layer 1 can be configured so as to include at least one selected from the group consisting of Group IV semiconductors, Group II-VI compound semiconductors, Group III-V compound semiconductors, Group IV-IV compound semiconductors, alloys containing homologous elements thereof, and oxide semiconductors, instead of the monocrystalline silicon semiconductor layer.

As described below, a part of the base layer 1 is separated and removed along a delamination layer, which is formed by ion implantation of a delamination material such as hydrogen. The base layer 1 is thinned by separating and removing the part of the base layer 1 in this manner by a heat treatment. As described below, the delamination layer is formed in the base layer 1 before a gate electrode 17 is patterned.

As shown in FIG. 1, the protective insulating film 37 is laminated on the surface of the glass substrate 38. A planarizing film 31 is also laminated on the protective insulating film 37. A gate oxide film 16 and the LOCOS oxide films 10 are formed on the planarizing film 31. A base layer 1, having the active region 51 formed therein, is laminated on the gate oxide film 16. Note that although not shown in the figure, it is preferable to cover the surface of the base layer 1 with an oxide film as an insulating film, together with the LOCOS oxide films 10.

The gate electrode 17, which is made of, e.g., polysilicon or the like, and sidewalls 24 are formed between the planarizing film 31 and the gate oxide film 16. The gate electrode 17 faces the channel region 13 with the gate oxide film 17 interposed therebetween. On the other hand, the sidewalls 24 are positioned on both sides of the gate electrode 17, and face the lightly doped impurity regions 23 with the gate oxide film 16 interposed therebetween.

Contact holes 35 are formed so as to extend through the planarizing film 31 at positions vertically overlapping the heavily doped impurity regions 30. A source electrode 36 and a drain electrode 36 are formed in the contact holes 35. The source electrode 36 and the drain electrode 36 are metal electrodes.

### [Manufacturing Method]

A manufacturing method of the semiconductor device S will be described below.

First, in an element portion forming step, an element portion D, which includes at least a part of a PMOS transistor 56 as an element, is formed in a base layer 1, which is, e.g., a monocrystalline silicon semiconductor layer. That is, the element portion D is formed in a wafer of a silicon substrate 1 (which corresponds to the base layer 1) made of a monocrystalline silicon semiconductor. As described later, the element portion forming step includes an insulating film forming step, a conductive layer forming step, and an electrode forming step.

For example, a heat treatment is performed at about 900 to 1,000°C in an oxidizing atmosphere to form a thermal oxide film on the surface of the silicon substrate 1. Thereafter, a silicon nitride film is formed on the surface of the thermal oxide film by a chemical vapor deposition (CVD) method or the like, and then the silicon nitride film and the thermal oxide film are patterned. The PMOS transistor 56 is later formed in a region where the silicon nitride film and the thermal oxide film are left.

Then, as shown in FIG. 2, a heat treatment is performed at about 900 to 1,000°C in an oxygen atmosphere to form LOCOS oxide films 10. The LOCOS oxide films 10 are formed in regions exposed from the silicon nitride film and the thermal oxide film in the silicon substrate 1. Subsequently, the insulating film forming step is performed. In this step, the silicon nitride film and the thermal oxide film are removed, and a heat treatment is performed at about 1,000°C in an oxygen atmosphere to form a gate oxide film 16 as an insulating film over the surface of the silicon substrate 1, as shown in FIG. 2.

Then, as shown in FIG. 2, the conductive layer forming step is performed to uniformly form a polysilicon layer 14 as a conductive layer on the surface of the gate oxide film 16. The polysilicon layer 14 is formed with a thickness of about 300 nm by a CVD method or the like. The polysilicon film 14 formed has a convex surface so as to conform to the convex surface profile of the LOCOS oxide films 10.

Thereafter, a delamination layer forming step is performed before the electrode forming step described below. As shown in FIG. 2, in this delamination layer forming step, a delamination material 32 is ion implanted into the silicon substrate 1 to form a delamination layer 33. Hydrogen is used as the delamination material 32. Note that an inert element such as helium (He) or neon (Ne) may be used instead of hydrogen. Alternatively, both hydrogen and the inert element may be used.

As shown in FIG. 2, the delamination layer 33 formed has a convex surface under the LOCOS oxide films 10 so as to reflect the surface profile of the polysilicon film 14.

Then, the electrode forming step is performed. In this step, as shown in FIG. 3, the polysilicon layer 14 is patterned by photolithography or the like to form a gate electrode 17 (which is also referred to as a poly gate electrode) between adjoining ones of the LOCOS oxide films 10.

Thereafter, as shown in FIG. 3, a P-type impurity element 22 such as boron is ion implanted by using the gate electrode 17 as a mask. Thus, P-type lightly doped impurity regions 23 are formed in the silicon substrate 1.

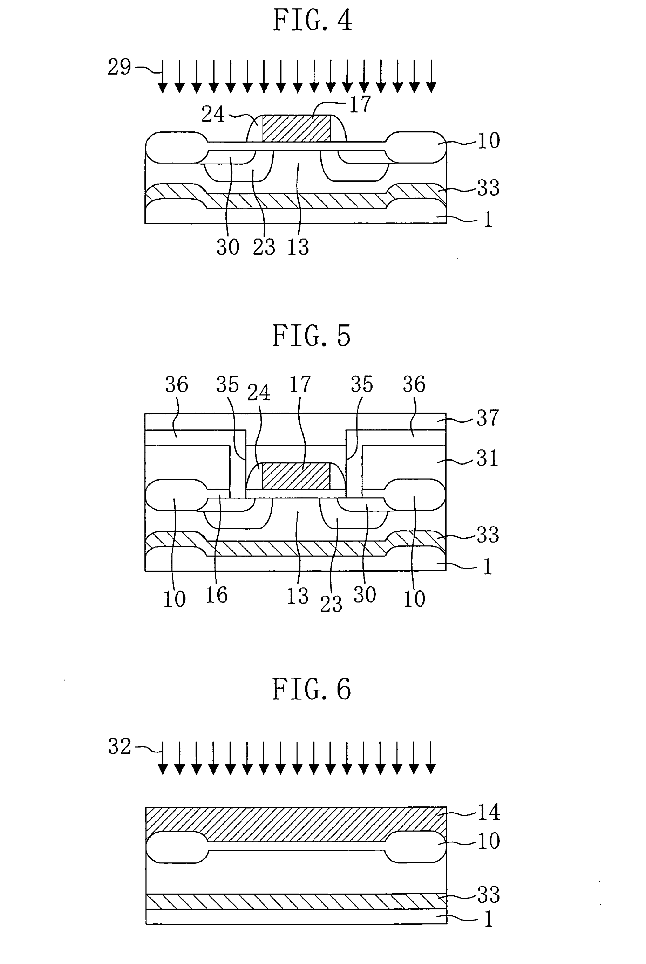

Then, a SiO₂ film is formed by a CVD method or the like so as to cover the gate oxide film 16, the LOCOS oxide films 10, and the like. The SiO₂ film is subjected to anisotropic dry etching to form sidewalls 24 of SiO₂ on both sides (the left and right sides in the figure) of the gate electrode 17, as shown in FIG. 4.

Then, as shown in FIG. 4, a P-type impurity element 29 such as boron is ion implanted into the silicon substrate 1 by using the gate electrode 17 and the sidewalls 24 as a mask. Thus, P-type heavily doped impurity regions 30 are formed outside the P-type lightly doped impurity regions 23.

Thereafter, as shown in FIG. 5, an insulating film, such as SiO₂ is formed so as to cover the gate electrode 17, the sidewalls 24, and the like. Then, the insulating film is planarized by a chemical mechanical polishing (CMP) method or the like to form a planarizing film 31.

Subsequently, as shown in FIG. 5, contact holes 35 are formed in the planarizing film 31 so as to expose the highly doped impurity regions 30 at the respective bottoms of the contact holes 35. Then, the contact holes 35 are filled with a metal material to form a source electrode 36 and a drain electrode 36 as metal electrodes. Note that FIG. 5 shows an example in which the source electrode 36 and the drain electrode 36 are formed by a single metal layer. However, the source electrode 36 and the drain electrode 36 may be formed by a plurality of metal layers.

Then, a protective insulating film 37 is formed over the surface of the planarizing film 36 so as to cover the PMOS transistor 56. The element portion forming step of forming the element portion D in the base layer 1 as the silicon substrate 1 is performed in this manner.

Thereafter, a bonding step is performed. In the bonding step, the silicon substrate 1 (the base layer 1), having the element portion D formed therein, is bonded to a substrate 38. For example, a glass substrate 38 is used as the substrate 38. More specifically, the surface of the silicon substrate 1, which is to be bonded to the glass substrate 38, is polished and planarized in advance by a CMP method or the like. Then, the respective surfaces of the protective insulating film 37 and the glass substrate 38 are cleaned by Standard Clean-1 (SC-1). Then, the element portion D is aligned with the glass substrate 38, and the silicon substrate 1 (the base layer 1) and the glass substrate 38 are bonded together at the surface of the protective insulating film 37 by self-bonding due to the van der Waals force.

Then, a separating step is performed. In the separating step, as shown in FIG. 1, the silicon substrate 1 (the base layer 1) bonded to the glass substrate 38 is heated to about 400 to 600°C to separate and remove a part of the silicon substrate 1 (the base layer 1) (i.e., a part which is located on a side opposite to the gate electrode 17 with the delamination layer 33 therebetween, and where the element portion D is not formed) along the delamination layer 33. As a result, the PMOS transistor 56 is transferred onto the glass substrate 38.

Then, the delamination layer 33 is removed by etching or the like, and the base layer 1 is thinned by etching, CMP, or the like until the LOCOS oxide films 10 are exposed, whereby element isolation is performed. Then, a heat treatment is performed to activate the impurity elements. The semiconductor device S is manufactured in this manner.

### [Advantages of First Embodiment]

As described above, according to the first embodiment, the delamination layer 33 is formed before the gate electrode 17 is patterned. This reduces a variation in implantation depth of hydrogen 32 into the silicon substrate 1 (the base layer 1) due to the shape of the gate electrode 17, in the region where the PMOS transistor 56 is to be formed. As a result, a flat delamination layer 33 can be formed in the silicon substrate 1 in this region.

Incidentally, ion implantation of hydrogen 32 is conventionally performed after formation of a planarizing film that covers the gate electrode 17. Thus, hydrogen needs to be implanted to a relatively deep position from the surface of the planarizing film in order to form the delamination layer. This not only causes hydrogen ions to be implanted in an excessively large area, but also forms a hydrogen ion implantation region reflecting the thickness distribution of the planarizing film. Thus, it is difficult to maintain a uniform implantation depth of hydrogen ions.

On the other hand, according to the first embodiment, hydrogen is ion implanted before the gate electrode 17 is patterned. This eliminates the need to form such a planarizing film. Thus, hydrogen can be ion implanted at relatively low energy to a relatively shallow position from the surface of the polysilicon layer 14 without being spread excessively, whereby the delamination layer can be formed appropriately. As a result, in the region where the PMOS transistor 56 is to be formed, a flat delamination layer 33 can be formed at a uniform depth while suppressing damage to the silicon substrate 1.

Moreover, since the delamination layer forming step is performed after the conductive layer forming step, the delamination layer 33 can be made to be less affected by heat applied to the silicon substrate 1 (the base layer 1) in other processes. As a result, the function of the delamination layer 33 can be maintained sufficiently until the separating step.

### (Second Embodiment)

FIGS. 6-9 show a second embodiment of the present invention.

FIGS. 6-9 are cross-sectional views illustrating manufacturing steps of a semiconductor device S of the second embodiment. Note that, in the following embodiments, the same parts as those of FIGS. 1-5 are denoted by the same reference characters, and detailed description thereof will be omitted.

The second embodiment is different from the first embodiment in that the polysilicon layer 14 has a convex surface in the first embodiment, whereas the surface of the polysilicon layer 14 is planarized in the second embodiment.

More specifically, when manufacturing the semiconductor device S of the second embodiment, the element portion forming step is performed similarly to the first embodiment until the insulating film forming step. Then, in the conductive layer forming step, as shown in FIG. 2, a polysilicon layer 14 as a conductive layer is first uniformly formed on the surface of a gate oxide film 16. Next, as shown in FIG. 6, the convex surface of the polysilicon layer 14 is polished and planarized by a CMP method or the like.

Then, as in the first embodiment, the delamination layer forming step is performed before the electrode forming step. More specifically, as shown in FIG. 6, a delamination material 32 is ion implanted into the silicon substrate 1 via the planarized polysilicon layer 14 to form a delamination layer 33. At this time, since the polysilicon layer 14 has a planarized surface, an entirely flat delamination layer 33 reflecting the planarized surface of the polysilicon layer 14 is formed in the silicon substrate 1.

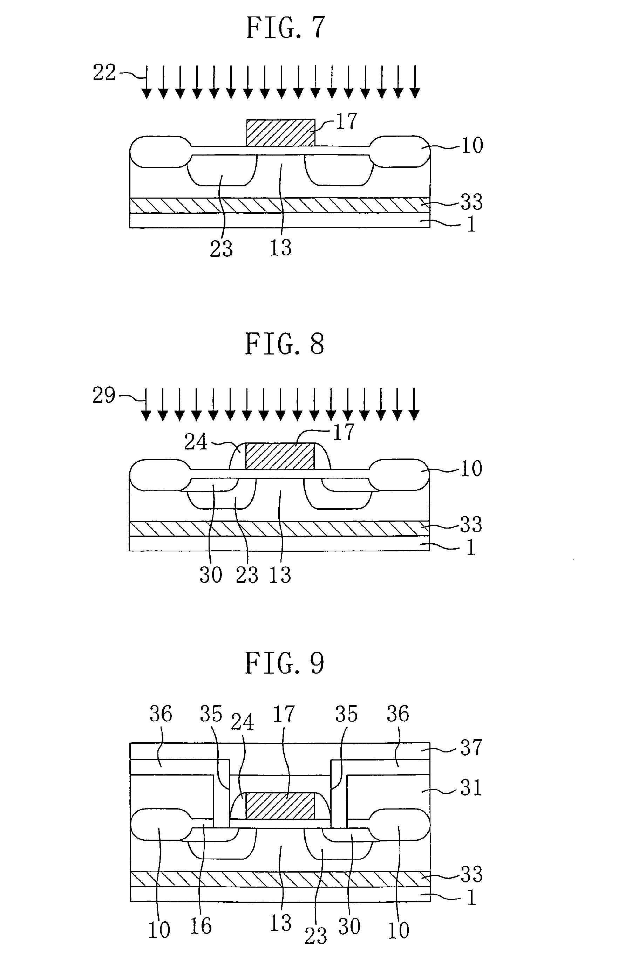

Thereafter, the electrode forming step is performed as in the first embodiment. In this step, as shown in FIG. 7, a gate electrode 17 is patterned, and a P-type impurity element 22 such as boron is ion implanted into the silicon substrate 1 to form P-type lightly doped impurity regions 23.

Subsequently, as in the first embodiment, as shown in FIG. 8, sidewalls 24 are formed, and a P-type impurity element 29 such as boron is ion implanted into the silicon substrate 1 to form P-type heavily doped impurity regions 30.

Then, as shown in FIG. 9, a planarizing film 31, contact holes 35, a source electrode 36, a drain electrode 36, and a protective insulating film 37 are formed as in the first embodiment. Then, the bonding step and the separating step are performed as in the first embodiment, whereby the semiconductor device S is manufactured.

### [Advantages of Second Embodiment]

As described above, in the second embodiment as well, the delamination layer 33 is formed before the gate electrode 17 is patterned. Thus, advantages similar to those of the first embodiment can be obtained. Moreover, in the second embodiment, the surface of the polysilicon layer 14 is planarized in the conductive layer forming step. Thus, the entirely flat delamination layer 33 can be formed in the later delamination layer forming step.

### (Third Embodiment)

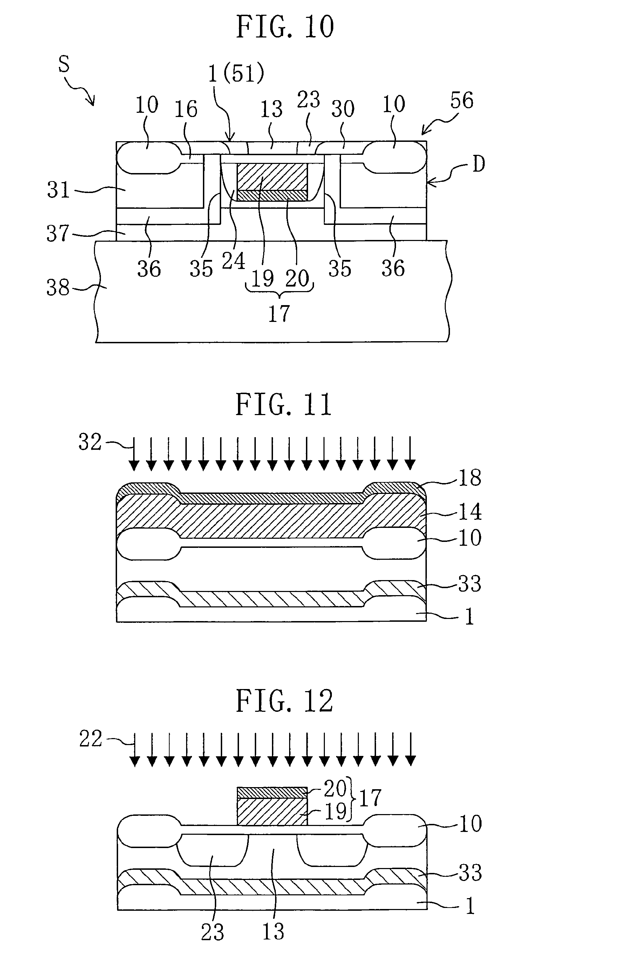

FIGS. 10-14 show a third embodiment of the present invention.

FIG. 10 is a cross-sectional view schematically showing the structure of a main part of a semiconductor device S according to the third embodiment. FIGS. 11-14 are cross-sectional views showing manufacturing steps of the semiconductor device S of the third embodiment.

The third embodiment is different from the first embodiment in that the gate electrode 17 is made only of polysilicon in the first embodiment, whereas the gate electrode 17 is formed by a polysilicon layer and a metal layer in the third embodiment.

More specifically, as shown in FIG. 10, the gate electrode 17 of the third embodiment is patterned on a gate oxide film 16, and is formed by a silicon layer portion 10 made of, e.g., polysilicon, and a metal layer portion 20 laminated thereon. The gate electrode 17 is formed between the glass substrate 38 and the base layer 1.

When manufacturing the semiconductor device S of the third embodiment, in the element portion forming step, the conductive layer forming step is performed after the insulating film forming step to uniformly form a polysilicon film 14 as a conductive layer on the surface of the gate oxide film 16, as shown in FIG. 11. Then, a metal film forming step is performed to uniformly laminate a metal film 18 on the surface of the polysilicon layer 14. At this time, both the polysilicon layer 14 and the metal film 18 have a convex surface so as to conform to the convex surface profile of the LOCOS oxide films 10. It is desirable to perform silicidation by rapid high-temperature annealing at this stage before hydrogen ion implantation. Then, as in the first embodiment, the delamination layer forming step is performed before the electrode formation step.

Thereafter, as shown in FIG. 12, in the electrode forming step, the polysilicon layer 14 and the metal film 18 are simultaneously patterned to form an island-shaped gate electrode 17. Then, a P-type impurity element 22 such as boron is ion implanted into the silicon substrate 1 to form P-type lightly doped impurity regions 23.

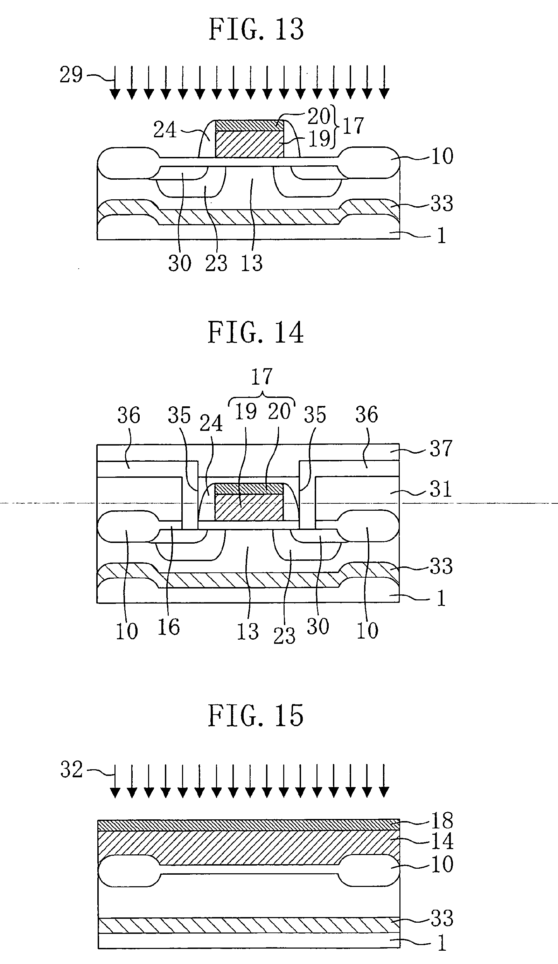

Subsequently, as in the first embodiment, as shown in FIG. 13, sidewalls 24 are formed, and then a P-type impurity element 29 such as boron is ion implanted into the silicon substrate 1 to form P-type heavily doped impurity regions 30. Then, a planarizing film 31, contact holes 35, a source electrode 36, a drain electrode 36, and a protective insulating film 37 are formed as shown in FIG. 14. Moreover, the bonding step and the separation step are performed as in the first embodiment, whereby the semiconductor device S is manufactured.

### [Advantages of Third Embodiment]

As described above, according to the third embodiment as well, the delamination layer 33 is formed before the gate electrode 17 is patterned. Thus, advantages similar to those of the first embodiment can be obtained. Moreover, in the third embodiment, the gate electrode 17 is formed by the silicon layer portion 19 and the metal layer portion 20 and is silicidated, whereby the resistance value of the gate electrode 17 can be reduced. That is, the flatness of the delamination layer 33 can be improved while increasing the conductive property of the gate electrode 17. Moreover, performing the heat treatment for silicidation before hydrogen ion implantation can prevent a reduction in function of the delamination layer 33 due to the heat treatment.

### (Fourth Embodiment)

FIGS. 15-18 show a fourth embodiment of the present invention.

FIGS. 15-18 are cross-sectional views illustrating manufacturing steps of a semiconductor device S of the fourth embodiment.

The fourth embodiment is different from the third embodiment in that the polysilicon layer 14 and the metal layer 18 have a convex surface in the third embodiment, whereas the respective surfaces of the polysilicon layer 14 and the metal layer 18 are planarized in the fourth embodiment.

More specifically, when manufacturing the semiconductor device S of the fourth embodiment, the element portion forming step is performed similarly to the first to third embodiments until the insulating film forming step. Then, in the conductive layer forming step, as shown in FIG. 15, a polysilicon layer 14 as a conductive layer is uniformly formed on the surface of a gate oxide film 16, and then the convex surface of the polysilicon layer 14 is polished and planarized by a CMP method or the like. Thereafter, a metal film 18 is laminated on the planarized surface of the polysilicon layer 14. The metal film 18 formed has a flat surface reflecting the surface of the polysilicon layer 14.

Subsequently, the delamination layer forming step is performed as in the third embodiment. More specifically, as shown in FIG. 15, a delamination material 32 such as hydrogen is ion implanted into the silicon substrate 1 via the planarized polysilicon layer 14 and the planarized metal film 18 to form a delamination layer 33. At this time, since the polysilicon layer 14 and the metal layer 18 have a planarized surface, an entirely flat delamination layer 33, which reflects the respective planarized surfaces of the polysilicon layer 14 and the metal film 18, is formed in the silicon substrate 1.

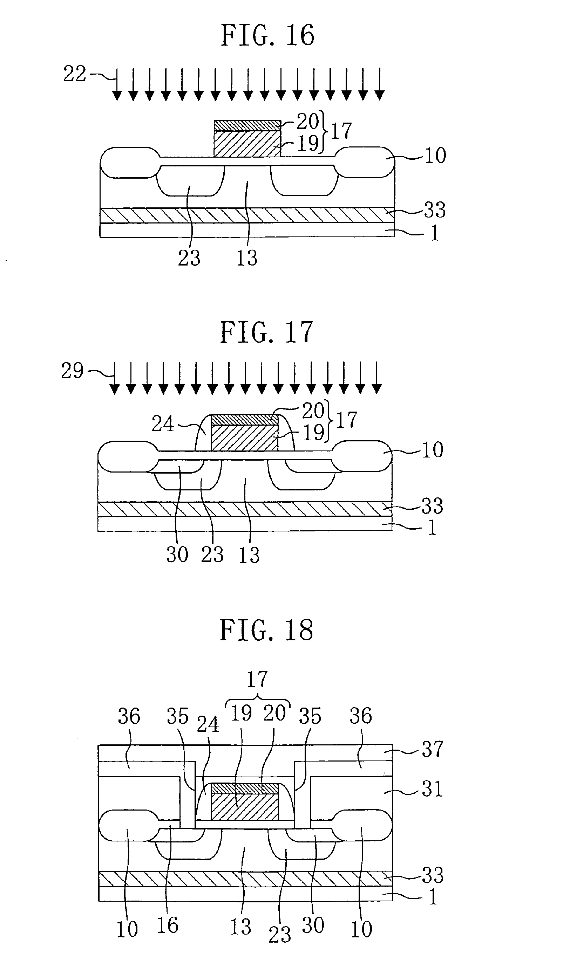

Then, as in the third embodiment, the electrode forming step is performed. In this step, as shown in FIG. 16, a gate electrode 17, which is formed by a silicon layer portion 19 and a metal layer portion 20, is patterned, and a P-type impurity element 22 such as boron is ion implanted into the silicon substrate 1 to form P-type lightly doped impurity regions 23.

Subsequently, as in the third embodiment, as shown in FIG. 17, sidewalls 24 are formed, and then a P-type impurity element 29 such as boron is ion implanted into the silicon substrate 1 to form P-type heavily doped impurity regions 30.

Thereafter, as shown in FIG. 18, a planarizing film 31, contact holes 35, a source electrode 36, a drain electrode 36, and a protective insulating film 37 are formed as in the third embodiment. Moreover, the bonding step and the separating step are performed as in the third embodiment, whereby the semiconductor device S is manufactured.

### [Advantages of Fourth Embodiment]

As described above, according to the fourth embodiment as well, the delamination layer 33 is formed before the gate electrode 17 is patterned. Thus, advantages similar to those of the first embodiment can be obtained. Moreover, since the gate electrode 17 is formed by the silicon layer portion 19 and the metal layer portion 20, advantages similar to those of the third embodiment can also be obtained. In addition, in the fourth embodiment, the surface of the polysilicon layer 14 is planarized in the conductive layer forming step, so that the metal film 18 that is laminated on the polysilicon layer 14 also has a flat surface. Thus, the entirely flat delamination layer 33 can be formed in the later delamination layer forming step.

### (Other Embodiments)

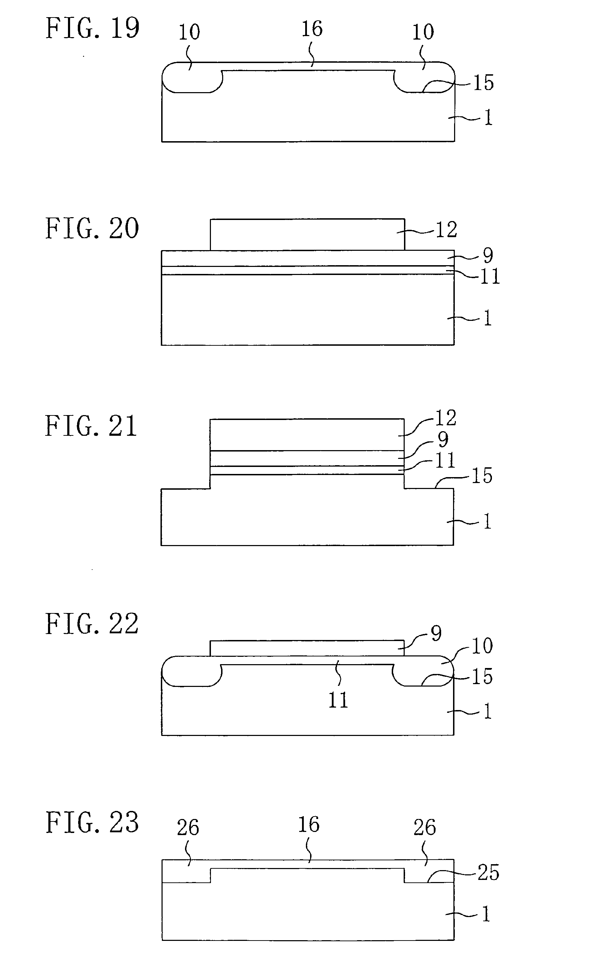

In the above embodiments, convex LOCOS oxide films 10 are formed by forming the LOCOS oxide films 10 on the flat silicon substrate 1. However, as shown in FIG. 19, the LOCOS oxide films 10 may be formed so as to be substantially flush with the gate oxide film 16.

FIG. 19 is a cross-sectional view showing planarized LOCOS oxide films 10. FIGS. 20-22 are cross-sectional views illustrating a process of forming the planarized LOCOS oxide films 10.

In order to form the planarized LOCOS oxide films 10, as shown in FIG. 20, an oxide film 11 is formed on a silicon substrate 1, and a silicon nitride film 9 is formed on the surface of the oxide film 11. Then, a resist 12 is formed in an island shape on the surface of the silicon nitride film 9 in a region where the PMOS transistor 56 is to be formed

Thereafter, as shown in FIG. 21, the silicon nitride film 9, the oxide film 11, and a part of the silicon substrate 1 are etched by using the resist 12 as a mask, thereby forming a plurality of grooves 15.

Subsequently, as shown in FIG. 22, the resist 12 is removed, and the silicon substrate 1 is thermally oxidized to form LOCOS oxide films 10 in the grooves 15 so that the surfaces of the LOCOS oxide films 10 are substantially flush with the oxide film 11.

Then, as shown in FIG. 19, the silicon nitride film 9 is removed by phosphoric acid (H₃PO₄) or the like, and the oxide film 11 is removed by hydrofluoric acid (HF) or the like. Thereafter, a gate oxide film 16 is formed. The planarized LOCOS oxide films 10 are formed in this manner.

Planarizing the LOCOS oxide films 10 in this manner can improve the flatness of the entire delamination layer 33 that is formed in a later step.

Instead of the LOCOS oxide films 10, element isolation insulating layers may be formed by so-called shallow trench isolation (STI). For example, as shown in FIG. 23, which is a cross-sectional view of element isolation insulating layers 26 formed by STI, a plurality of trenches 25 are formed in a silicon substrate 1, the element isolation insulating layers 26 are formed in the trenches 25, and a gate oxide film 16 is formed between adjoining ones of the element isolation insulating layers 26. This method also enables the respective surfaces of the element isolation insulating layers 26 to be planarized so as to be substantially flush with the gate oxide film 16. Thus, the flatness of the entire delamination layer 33 can be improved.

Although MOS transistors are described as an example of the elements in the first embodiment, the present invention is not limited to this. That is, the present invention is similarly applicable to other elements having a locally protruding part.

The electrode that is formed in the electrode forming step does not necessarily form the entire gate electrode 17, but may form at least a part of a gate electrode in a MOS transistor.

In the above embodiments, the impurity elements ion-implanted into the silicon substrate 1 are thermally activated after the element portion D is bonded to the glass substrate 38. However, the present invention is not limited to this, and the impurity elements may be activated by a rapid heat treatment such as rapid thermal annealing (RTA) right after the impurity element is ion implanted into the heavily doped impurity regions.

### INDUSTRIAL APPLICABILITY

As described above, the present invention is useful for semiconductor devices for use in, e.g., LCDs, and manufacturing methods thereof. The present invention is especially suitable in the case of forming a flat delamination layer in a base layer.

## Claims

1. A method for manufacturing a semiconductor device, comprising:
an element portion forming step of forming in a base layer an element portion that includes at least a part of an element including an electrode;
a delamination layer forming step of ion implanting a delamination material into the base layer to form a delamination layer;
a bonding step of bonding to the substrate the base layer having the element portion formed therein; and
a separating step of separating and removing along the delamination layer a part of the base layer bonded to the substrate, where the element portion is not formed, wherein
the element portion forming step includes
an insulating film forming step of forming an insulating film on a surface of the base layer,
a conductive layer forming step of uniformly forming a conductive layer on a surface of the insulating film, and
an electrode forming step of patterning the conductive layer to form the electrode, and
the delamination layer forming step is performed before the electrode forming step.

2. The method of claim 1, further comprising:
a metal film forming step of laminating a metal film on a surface of the conductive layer, wherein
in the electrode forming step, the conductive layer and the metal film are patterned to form the electrode.

3. The method of claim 1 or 2, wherein
the surface of the conductive layer is planarized in the conductive layer forming step.

4. The method of claim 1, wherein
the delamination layer forming step is performed after the conductive layer forming step.

5. The method of claim 1, wherein
the conductive layer is made of polysilicon.

6. The method of claim 2, wherein
the conductive layer is made of polysilicon, and is silicidated after the metal film forming step.

7. The method of claim 1, wherein
the delamination material is hydrogen or an inert element.

8. The method of claim 1, wherein
the base layer is a monocrystalline silicon layer.

9. The method of claim 1, wherein
the substrate is a glass substrate.

10. The method of claim 1 or 2, wherein
the electrode forms at least a part of a gate electrode of a MOS transistor.

11. The method of claim 1, wherein
a surface of the base layer, which is to be bonded to the substrate, is planarized in advance in the bonding step.

12. A semiconductor device, comprising:
a substrate;
a base layer bonded to the substrate with a part of the base layer being separated and removed along a delamination layer containing a delamination material; and
an element portion including at least a part of an element, and formed in the base layer, wherein
an electrode of the element is formed by a silicon layer portion and a metal layer portion laminated thereon, and is formed between a substrate of the substrate and the base layer.

13. The semiconductor device of claim 12, wherein
the electrode is silicidated.

14. The semiconductor device of claim 12, wherein
the delamination layer is formed in the base layer before the electrode of the element is patterned.

15. The semiconductor device of claim 12, wherein
the delamination material is hydrogen or an inert element.

16. The semiconductor device of claim 12, wherein the base layer is a monocrystalline silicon layer.

17. The semiconductor device of claim 12, wherein the substrate is a glass substrate.
